# EUROPÄISCHE PATENTSCHRIFT

(11) **EP 0 524 457 B1**
(45) Veröffentlichungstag und Bekanntmachung des Hinweises auf die Patenterteilung: **26.10.1994**
(21) Anmeldenummer: 92111144.9
(22) Anmeldetag: 01.07.1992
(51) Int. Cl.: H01S 3/19, H01S 3/103

(54) **TTG-DFB-Laserdiode**
TTG-DFB laserdiode
TTG-DFB diode laser

(30) Priorität: 26.07.1991 DE 4124873
(43) Veröffentlichungstag der Anmeldung: 27.01.1993
(73) Patentinhaber: SIEMENS AKTIENGESELLSCHAFT, 80333 München (DE)
(72) Erfinder: Thulke, Wolfgang, Dr.rer.nat., W 8000 München 83 (DE); Illek, Stefan, Dr.rer.nat., W-8152 Feldkirchen-Westerham (DE)

(56) Entgegenhaltungen:
- EP-A- 0 296 066
- EP-A- 0 360 011
- EP-A- 0 383 958

## Beschreibung

Die vorliegende Anmeldung betrifft eine Laserdiode mit elektrisch durchstimmbarer Emissionswellenlänge mit TTG-DFB-Struktur.

Die TTG-DFB-Laserdiode der europäischen Patentanmeldung EP 0 360 011 wird wegen ihrer weiten, stufenlosen Durchstimmbarkeit ihrer Emissionswellenlänge als besonders geeignet für den Einsatz in zukünftigen optischen Nachrichtenübertragungssystemen angesehen. Vielversprechend ist ihr Einsatz z. B. als Lokaloszillator in optischen Überlagerungsempfängern. Bei dieser Laserdiode sind eine aktive Schicht und eine Abstimmschicht vertikal übereinander und durch eine Zwischenschicht voneinander getrennt angeordnet, wobei über Seitenbereiche und durch die Zwischenschicht hindurch getrennte Strominjektionen in die Abstimmschicht und die aktive Schicht erfolgen können. In bisher realisierten Ausführungsformen ist diese TTG-DFB-Laserdiode auf einem p-dotierten Substrat aufgebaut. Über das Substrat wird eine der beiden wesentlichen Laserschichten, d. h. die aktive Schicht oder die Abstimmschicht, je nachdem welche auf der dem Substrat zugewandten Seite der Zwischenschicht angeordnet ist, elektrisch angesteuert. Das Substrat muß daher gegen den Subträger, der häufig mit der elektrischen Masse gleichzusetzen ist, elektrisch isoliert werden, was den Fertigungsaufwand erhöht.

Aufgabe der vorliegenden Erfindung ist es, eine TTG-DFB-Laserdiode anzugeben, bei der ein für die Ansteuerung der aktiven Schicht und der Abstimmschicht gemeinsames Potential über das Substrat angelegt werden kann.

Diese Aufgabe wird mit der Laserdiode mit den Merkmalen des Anspruches 1 gelöst. Weitere Ausgestaltungen ergeben sich aus den abhängigen Ansprüchen.

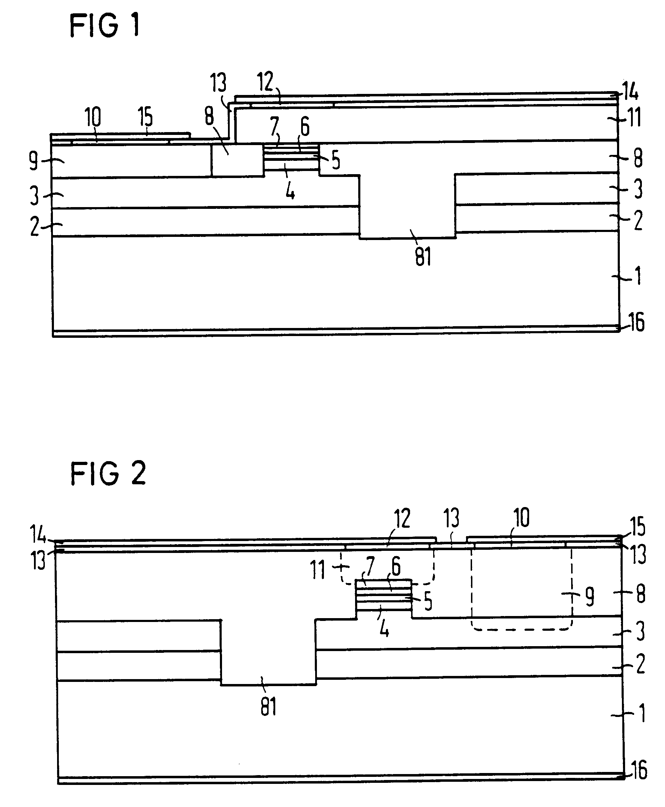

Bei der erfindungsgemäßen Laserdiode ist ein Seitenbereich, über den der Stromfluß in die Zwischenschicht erfolgt, mit dem leitfähigen Substrat verbunden. Die jeweils der Zwischenschicht abgewandten Seiten der aktiven Schicht und der Abstimmschicht sind mit entgegengesetzt dotiertem Halbleitermaterial, das auf der Oberfläche des Bauelementes kontaktiert wird, verbunden. Es folgt eine Beschreibung der erfindungsgemäßen Laserdiode anhand der Figuren 1 und 2, die zwei Ausführungsformen im Querschnitt zeigen.

Bei der Ausführungsform der erfindungsgemäßen TTG-DFB-Laserdiode der Fig. 1 ist auf einem n-leitenden Substrat 1, das als elektrische Masse dienen kann und auf seiner Unterseite mit einem Kontakt 16 versehen ist, eine Schichtfolge aufgebracht. Die für dieses Ausführungsbeispiel angegebenen Vorzeichen der jeweiligen Dotierungen können auch entgegengesetzt sein. Unmittelbar auf dem Substrat findet sich eine semiisolierende Schicht 2 und eine p-leitend dotierte untere Mantelschicht 3. Bei einem z. B. mit Schwefel dotierten InP-Substrat kann die semiisolierende Schicht 2 z. B. InP, das mit Eisen semiisolierend gemacht wurde, sein und die untere Mantelschicht 3 mit Zink dotiertes InP. Die untere Mantelschicht 3 ist so dick und ihre Dotierung so hoch, daß ein ausreichend geringer Querwiderstand von wenigen Ohm auf einer Breite von 10 bis 20 µm gewährleistet ist.

Auf die untere Mantelschicht 3 sind die Halbleiterschichten für die Laserstruktur aufgebracht und als schmaler Streifen strukturiert. Die Struktur umfaßt eine Abstimmschicht 4 (z. B. InGaAsP der Wellenlänge 1,3 µm), eine n-dotierte Zwischenschicht 5 (z. B. InP:Sn), eine aktive Schicht 6 (z. B. InGaAsP der Wellenlänge 1,55 µm) und gegebenenfalls eine p-leitend dotierte Schutzschicht 7 (z. B. mit Zink dotiertes InP). Die Abstimmschicht 4 kann auch oberhalb der Zwischenschicht 5 angeordnet sein; die aktive Schicht 6 befindet sich dann unterhalb der Zwischenschicht 5. Die Abstimmschicht 4 kann eine Gitterkorrugation enthalten; diese kann auch in einer weiteren, hier nicht dargestellten Schicht in der Nähe der Laserschichten lokalisiert sein.

Dieser Streifen ist seitlich in eine n-leitende Mantelschicht 8 (z. B. mit Zinn dotiertes InP) eingebettet. Diese Mantelschicht 8 füllt auch eine Unterbrechung 81 der semiisolierenden Schicht 2 und der unteren Mantelschicht 3 seitlich des Laserstegs aus, so daß durch diese sich grabenförmig über die gesamte Länge des Laserstreifens erstreckende Unterbrechung 81 die Mantelschicht 8 elektrisch leitend mit dem Substrat 1 verbunden ist. Über den Kontakt 16 und durch das Substrat 1 und die Mantelschicht 8 kann daher eine n-leitende Verbindung zu der Zwischenschicht 5 hergestellt werden. Es ist daher eine zentrale Strominjektion in diese Zwischenschicht 5 vom Substrat 1 her möglich. Der Kontakt 16 wird dann z. B. auf Massepotential gelegt. Die Unterbrechung 81 befindet sich auf einer Seite des Laserstreifens. Auf der anderen Seite des Laserstreifens ist der n-leitend dotierte Anteil der Mantelschicht 8 längs des Laserstreifens nur wenige Mikrometer breit. Seitlich schließt an der dem Laserstreifen abgewandten Seite ein p-leitender lateraler Bereich 9 (z. B. mit Zink dotiertes InP) an. Dieser laterale Bereich 9 kann durch einen umdotierten Anteil der Mantelschicht 8 oder durch eine eigens aufgebrachte p-leitend dotierte laterale Schicht gebildet sein. Auf diesen lateralen Bereich 9 ist eine streifenförmige, hoch p-leitend dotierte Kontaktschicht 10 (z. B. mit Zink dotiertes InGaAs) aufgebracht. Mittels eines auf diese Kontaktschicht 10 aufgebrachten Kontaktes 15 ist durch den lateralen Bereich 9 und die darunter befindliche untere Mantelschicht 3 eine elektrisch leitende Verbindung zu der untersten Laserschicht (Abstimmschicht 4) herstellbar.

Der in die Mantelschicht 8 eingebettete Lasersteg wird von oben von einem p-leitend dotierten oberen Bereich 11 überdeckt, der durch einen umdotierten Anteil der Mantelschicht 8 oder durch eine weitere, p-leitend dotierte obere Mantelschicht 11 (z. B. mit Zink dotiertes InP), die den Kontakt 15 auf dem p-leitend dotierten lateralen Bereich 9 freiläßt, gebildet wird. Auf diesem oberen Bereich 11 ist eine hoch p-leitend dotierte Kontaktschicht 12 streifenförmig längs des Laserstreifens aufgebracht, die z. B. mit Zink dotiertes InGaAs ist und mit der die oberste Laserschicht (aktive Schicht 6) elektrisch leitend verbunden ist. Der obere Bereich 11 reicht auf der der Unterbrechung 81 abgewandten Seite des Steges nur wenige Mikrometer über den Lasersteg hinaus, so daß keine leitende Verbindung zwischen dem oberen Bereich 11 und dem lateralen Bereich 9 besteht.

Die beiden streifenförmigen Kontaktschichten 10 und 12 sind durch eine Oxidschicht 13 gegeneinander isoliert, die die Oberfläche der Schichtenfolge außerhalb der Kontaktstreifen bedeckt. Auf der über dem Lasersteg angeordneten Kontaktschicht 12 befindet sich ebenfalls ein Kontakt 14.

Die obere Mantelschicht 11 kann als Schichtanteil der Mantelschicht 8 wie in Fig. 2 dargestellt eine planare Oberfläche besitzen. In dem Ausführungsbeispiel der Fig. 2 sind der p-leitend dotierte laterale Bereich 9 auf der der Unterbrechung 81 gegenüberliegenden Seite des Laserstreifens bis in die untere Mantelschicht 3 hineinreichend und der p-leitend dotierte obere Bereich 11 oberhalb des Laserstreifens und bis in die oberste p-leitend dotierte Schicht dieses Streifens reichend ausgebildet. Der übrige Aufbau entspricht dem der Fig. 1.

Vorteile der erfindungsgemäßen TTG-DFB-Laserdiode sind der Aufbau auf leitendem Substrat als gemeinsamem elektrischem Massepotential für die aktive Schicht und die Abstimmschicht und die gute Integrationsfähigkeit der Laserstruktur mit anderen elektronischen und optoelektronischen Funktionselementen auf dem gleichen Substrat. Die weiteren Funktionselemente können auf der semiisolierenden Schicht 2 elektrisch voneinander isoliert angeordnet sein.

## Patentansprüche

1. Laserdiode auf einem für elektrische Leitung eines ersten Leitfähigkeitstyps dotierten Substrat (1) mit einer streifenförmigen Schichtstruktur, die eine Zwischenschicht (5) zwischen zwei speziellen Schichten (4, 6), von denen eine eine für Strahlungserzeugung vorgesehene aktive Schicht (4) ist und die andere eine für eine Wellenlängenänderung vorgesehene Abstimmschicht (6) ist,
bei der eine an diese Schichtstruktur beidseitig lateral angrenzende Mantelschicht (8), die im wesentlichen für den ersten Leitfähigkeitstyp dotiert ist und die mit dem Substrat (1) elektrisch leitend verbunden ist, vorhanden ist,
bei der ein oberer Bereich (11), der für einen entgegengesetzten, zweiten Leitungstyp dotiert ist, über der Schichtstruktur und ein davon getrennter lateraler Bereich (9), der für diesen zweiten Leitungstyp dotiert ist und der mit der dem Substrat (1) zugewandten Seite der Schichtstruktur elektrisch leitend verbunden ist, ausgebildet sind,
bei der auf dem oberen Bereich (11) eine zentrale Kontaktschicht (12) und auf dem lateralen Bereich (9) eine laterale Kontaktschicht (10) aufgebracht sind und
bei der Kontakte (14, 15, 16) auf dieser zentralen Kontaktschicht (12), auf dieser lateralen Kontaktschicht (10) und auf dem Substrat (1) aufgebracht sind, so daß eine getrennte Strominjektion durch die Zwischenschicht (5) in jede der speziellen Schichten (4, 6) möglich ist.

2. Laserdiode nach Anspruch 1,
bei der eine für den zweiten Leitungstyp dotierte untere Mantelschicht (3) vorhanden ist, die den lateralen Bereich (9) mit der dem Substrat (1) zugewandten Seite der Schichtstruktur elektrisch verbindet.

3. Laserdiode nach Anspruch 1 oder 2,
bei der der obere Bereich (11) durch eine obere Schicht der Mantelschicht (8) gebildet wird.

4. Laserdiode nach einem der Ansprüche 1 bis 3,
bei der der obere Bereich (11) an eine für den zweiten Leitungstyp dotierte streifenförmige Schutzschicht (7) der Schichtstruktur angrenzt.

5. Laseriode nach einem der Ansprüche 1 bis 4,
bei der der laterale Bereich (9) durch eine laterale obere Schicht der Mantelschicht (8) gebildet wird.

6. Laserdiode nach einem der Ansprüche 1 bis 5,
bei der eine semiisolierende Schicht (2) vorhanden ist, die das Substrat (1) von für den zweiten Leitungstyp dotiertem Halbleitermaterial isoliert.

7. Laserdiode nach einem der Ansprüche 1-6,
bei der die Abstimmschicht (6) auf der dem Substrat (1) zugewandten Seite der Zwischenschicht (5) angeordnet ist.

8. Laserdiode nach einem der Ansprüche 1-6,
bei der die Abstimmschicht (6) auf der dem Substrat (1) abgewandten Seite der Zwischenschicht (5) angeordnet ist.

## Claims

1. Laser diode on a substrate (1) doped for electrical conduction of a first conductivity type, having a stripe-shaped layer structure which comprises an intermediate layer (5) between two specific layers (4, 6), one of which is an active layer (4) provided for radiation generation and the other of which is a tuning layer (6) provided for a wavelength change, in which a confinement layer (8), which laterally adjoins this layer structure on both sides, is substantially doped for the first conductivity type and is electrically conductively connected to the substrate (1), is present, in which an upper region (11), which is doped for an opposite, second conductivity type, is formed over the layer structure and a lateral region (9), which is separate therefrom, is doped for this second conductivity type and is electrically conductively connected to that side of the layer structure which faces the substrate (1) is formed, in which a central contact layer (12) is applied to the upper region (11) and a lateral contact layer (10) is applied to the lateral region (9) and in which contacts (14, 15, 16) are applied to this central contact layer (12), to this lateral contact layer (10) and to the substrate (1), so that separate current injection through the intermediate layer (5) into each of the specific layers (4, 6) is possible.

2. Laser diode according to Claim 1, in which a lower confinement layer (3) is present, which is doped for the second conductivity type and which electrically connects the lateral region (9) to that side of the layer structure which faces the substrate (1).

3. Laser diode according to Claim 1 or 2, in which the upper region (11) is formed by an upper layer of the confinement layer (8).

4. Laser diode according to one of Claims 1 to 3, in which the upper region (11) adjoins a stripe-shaped protective layer (7) of the layer structure, which protective layer is doped for the second conductivity type.

5. Laser diode according to one of Claims 1 to 4, in which the lateral region (9) is formed by a lateral upper layer of the confinement layer (8).

6. Laser diode according to one of Claims 1 to 5, in which a semi-insulating layer (2) is present, which insulates the substrate (1) from semiconductor material doped for the second conductivity type.

7. Laser diode according to one of Claims 1 to 6, in which the tuning layer (6) is disposed on that side of the intermediate layer (5) which faces the substrate (1).

8. Laser diode according to one of Claims 1 to 6, in which the tuning layer (6) is disposed on that side of the intermediate layer (5) which is remote from the substrate (1).

## Revendications

1. Diode laser disposée sur un substrat (1) dopé pour présenter une conduction électrique avec un premier type de conductivité, comportant une structure stratifiée en forme de bande, une couche intermédiaire (5) disposée entre deux couches particulières (4,6), dont l'une est une couche active (4) prévue pour la production d'un rayonnement et dont l'autre est une couche de réglage d'accord (6) prévue pour une modification de la longueur d'onde, et
dans laquelle il est prévu une couche enveloppe (8) qui jouxte latéralement, des deux côtés, cette structure stratifiée et qui est dopée essentiellement pour présenter le premier type de conductivité et est reliée de façon électriquement conductrice au substrat (1), et
dans laquelle il est prévu une région supérieure (11), qui est dopée pour fournir un second type de conductivité opposé et est disposée au-dessus de la structure stratifiée, et une région latérale (9), qui est séparée de la région supérieure, est dopée pour présenter ce second type de conductivité et est reliée d'une manière électriquement conductrice à la face de la structure stratifiée, tournée vers le substrat (1), et dans laquelle une couche centrale de contact (12) est disposée sur la région supérieure (11), et une couche latérale de contact (10) est disposée sur la région latérale (9), et
dans laquelle les contacts (14,15,16) sont disposés sur cette couche centrale de contact (12), sur cette couche latérale de contact (10) et sur le substrat (1), de sorte qu'une injection séparée de courant est possible, à travers la couche intermédiaire (5), dans chacune des couches spéciales (4, 6).

2. Diode laser suivant la revendication 1, dans laquelle il est prévu une couche enveloppe inférieure (3), qui est dopée pour présenter le second type de conductivité et qui relie électriquement la région latérale (9) à la face de la structure stratifiée, tournée vers le substrat (1).

3. Diode laser suivant la revendication 1 ou 2, dans laquelle la région supérieure (11) est formée par une couche supérieure de la couche enveloppe (8).

4. Diode laser suivant l'une des revendications 1 à 3, dans laquelle la région supérieure (11) jouxte une couche de protection en forme de bande (7), dopée pour présenter le second type de conductivité, de la structure stratifiée.

5. Diode laser suivant l'une des revendications 1 à 4, dans laquelle la région latérale (9) est formée par une couche latérale supérieure de la couche enveloppe (8).

6. Diode laser suivant l'une des revendications 1 à 5, dans laquelle il est prévu une couche semi-isolante (2), qui isole le substrat (1) vis-à-vis du matériau semiconducteur dopé pour présenter le second type de conductivité.

7. Diode laser suivant l'une des revendications 1-6, dans laquelle la couche de réglage d'accord (6) est disposée sur la face de la couche intermédiaire (5), tournée vers le substrat (1).

8. Diode laser suivant l'une des revendications 1-6, dans laquelle la couche de réglage d'accord (6) est disposée sur la face de la couche intermédiaire (5), tournée à l'opposé du substrat (1).
